Europäisches Patentamt

European Patent Office

Office européen des brevets

(19)

(11) Publication number: **0 488 555 A2**

# EUROPEAN PATENT APPLICATION

(12)

(21) Application number: **91310545.8**

(22) Date of filing: **14.11.91**

(51) Int. Cl.5: **H05K 3/00**, H05K 3/38,
C23C 18/22

(30) Priority: **29.11.90 US 619902**

(43) Date of publication of application:
**03.06.92 Bulletin 92/23**

(84) Designated Contracting States:
**BE DE FR GB IT NL**

(71) Applicant: **MACDERMID INCORPORATED**
**245 Freight Street**
**Waterbury, Connecticut 06702(US)**

(72) Inventor: **Grunwald, John T.**
**4 Hameshorer Street**
**Ramat Gan(IL)**

(74) Representative: **Pendlebury, Anthony et al**
**PAGE, WHITE & FARRER 54 Doughty Street**
**London WC1N 2LS(GB)**

(54) **Compositions and processes for use in the fabrication of printed circuits.**

(57) Compositions which combine, in functionally stable aqueous solution form, multiple functionalities required in the fabrication of printed circuits, such as neutralizing of oxidizing species remaining on surfaces to be metallized as a result of desmearing or etch-back or other like treatment of through-holes with strong oxidizing agents, and/or micro-etching of copper surfaces to enhance adhesion thereto of electroless or electrolytic metal plating, and/or cleaning of soils, oils, etc. from copper surfaces for similar purpose, and/or conditioning through-holes to enhance and uniformize their absorption of catalyst prior to electroless metallization. These compositions enable significant reduction in the number of steps and processing time associated with conventional printed circuit fabrication, and importantly eliminate traditional intervening rinsing requirements, with consequent reduction in waste water treatment needs.

The present invention relates to the fabrication of printed circuits and, more particularly, to compositions and processes for use in the fabrication of printed circuits.

The fabrication of printed circuits, be they rigid, flexible or flexible/rigid types of circuits, involves an enormous number and array of disparate individual processing steps, ranging the gamut from cleaning procedures, to photoimaging techniques, to metal deposition processes, and the like. Each step is necessary in its own right to achieve some particular end or effect, and most steps are seemingly incompatible in the sense of involving different types of materials or chemicals or conditions. This not only precludes combining these steps into fewer steps in an effort to economize processing, but also requires that thorough water rinsing be conducted after each step (or in some cases, series of steps) to avoid undesirable carry over of processing materials, and the like, into subsequent fabrication steps. Needless to say, the number and variety of steps add greatly to the cost of printed circuit fabrication, and the extensive rinsing requirements lead to significant costs associated with environmentally-appropriate treatment of the resultant waste water streams.

By way of brief illustration, double-sided and multilayer printed circuits offer good cases in point. In double-sided printed circuits, circuitry patterns are arranged on opposite sides of an insulating substrate material; in multilayer circuits, the printed circuit consists of one or more alternating circuitry innerlayers separated by insulating substrate material, as well as circuitry patterns on outer-facing surfaces of the multilayer board. In each case, metallized through-holes are the means provided for establishing conductive interconnection between or among the circuitry layers.

In the fabrication of double-sided and multilayer printed circuits, very stringent specifications must be met regarding the physical and electrical integrity of the metallized through-hole connections. In a typical fabrication sequence of the type designed to meet these specifications in multilayer circuits, the precursor composite of alternating circuitry layers and insulating substrate material has through-holes drilled or punched therethrough at predetermined locations. The hole surfaces consequently are made up of areas of insulating substrate material (often with exposed glass fibers where the substrate is a typical glass-reinforced resin) and edges of the innerlayer circuitry layers. Metallization of the through-hole surfaces is typically accomplished through electroless metal (e.g., copper) plating, but numerous steps are first required in order to insure that the metallization process will produce a void-free adherent deposit of metal sufficient to meet specifications.

For example, the hole-forming process typically results in a smearing of the insulating material over the innerlayer circuitry edges which, if not removed, will interpose an insulating barrier between the circuitry innerlayer edges and the subsequently-applied metal plating which can interfere with effective conductive interconnection, via the through-holes, among circuitry layers. Also in many cases the circuitry innerlayer edges are not sufficiently exposed at the through-hole surface to permit effective adherence thereto of the subsequently-applied metal plating. Still further, the hole-forming process might leave the resin areas insufficiently micro-roughened to adherently accept the subsequently-applied metal plating. Yet further, even with such problems being taken into account, there is still difficulty in obtaining a void-free adherent metal plating on the hole surfaces, often because the exposed glass fibers do not readily absorb the catalytic species required to there trigger metal depositing, and further because the different surfaces presented at the hole (resin, fiber, metal circuitry edges) exhibit different degrees of catalyst absorption and metal plating coverage and adherence.

The addressing of these problems leads to a multitude of additional processing steps. In a typical sequence, the through-hole surfaces are treated with a relatively strong oxidizing agent (e.g., alkaline permanganate, chromic acid) to effect a desmearing of innerlayer circuitry edges and/or an etch-back of resin to expose innerlayer circuitry edges and/or an alteration of the topography of the hole surface resin. These oxidizing species are incompatible with the chemicals used in metal deposition, and thus the multilayer board must be extensively water rinsed and then treated with a neutralizing (e.g., reducing) agent to eliminate any residual oxidizing species on the surfaces. Thereafter, following extensive rinsing away of the neutralizing agents, it is necessary to subject the multilayer board to cleaning agents to remove soils, oils, and the like from outer-facing planar copper surfaces of the composite (which copper surfaces also are to receive metal plating during the through-hole metallization process). In some cases it is necessary to rinse away these cleaning agents before contact of the multilayer board with a through-hole conditioner, i.e., an agent which increases and uniformizes the absorptivity of the through-hole surfaces to the catalytic species and metal deposit later applied, while in other cases the through-hole conditioner can be made a part of the cleaning solution. In any event, the cleaner/conditioner is rinsed prior to the next step, which involves a microetching of the outer-facing copper surfaces for the purposes of removing excess conditioner from these surfaces, removing surface oxides, and micro-etching the copper surface to enhance metal adhesion thereto in the subsequent through-hole metallization process. Following further rinsing, the surfaces to be plated (through-holes and outer-facing copper surfaces) are catalytically activated and then metallized using, e.g., an electroless copper depositing bath.

There are numerous steps both prior and subsequent to the foregoing sequence, but it can be readily appreciated that, even as to this particular subsequence, there are numerous distinct steps and numerous rinsing requirements. While the combining of any one or more such steps might suggest itself as a desirable goal for economizing the process and reducing waste water processing requirements, the simple fact is that these steps are generally quite incompatible in respect of the nature of their chemical compositions and/or processing conditions, thereby precluding attainment of any desirable combining efforts.

The present invention provides compositions and processes which enable the combining into a single-step of a multiplicity of the steps required in the fabrication of printed circuits, particularly printed circuits of the double-sided or multilayer type having through-holes requiring metallization.

The present invention relates to fabrication sequences for through-hole-containing double-sided and multilayer printed circuits of the type where oxidizing agents are employed in effecting desmearing and/or etchback and/or alteration of the topography of the insulating substrate material of the hole surface, and which thus require neutralization of oxidizing species before subsequent processing steps, the invention providing compositions to effect this neutralization while at the same time effecting the necessary cleaning, conditioning and micro-etching processes which must precede through-hole metallization.

In particular, the present invention provides compositions for effecting in one step the cleaning, conditioning and micro-etching operations which precede through-hole metallization in fabrication sequences for double-sided and multilayer printed circuits.

According to one aspect of the present invention there is provided compositions which comprise both (1) a reducing agent effective to neutralize the residual oxidizing species which result from treatment of through-hole-containing printed circuits to effect desmearing and/or etch-back and/or alternation of substrate topography at the through-hole surfaces, and (2) an oxidizing agent effective to micro-etch exposed (e.g., outer-facing) copper surfaces of the printed circuit. In a preferred embodiment, this composition further comprises agents effective to clean exposed copper surfaces as well as to condition through-hole surfaces to enhance absorption of the catalytic species necessary for through-hole metallization. In yet another embodiment of the invention, for situations, for example, where the processing cycle is one not requiring desmear or etch-back or through-hole topography alteration with oxidizing agents, and hence not requiring neutralization of oxidizing species, compositions are provided which effect, in one step, the required cleaning, conditioning and micro-etching preparatory to through-hole metallization.

Through provision of compositions of the type described, it is possible to substantially reduce the overall number of processing steps required in the fabrication of printed circuits. In the fabrication of multilayer circuits, for example, a traditional sequence of permanganate treatment, followed by rinsing, followed by neutralization of residual manganese species, following by rinsing, followed by cleaner/conditioner, followed by rinsing, followed by micro-etching, followed by rinsing, can be replaced with a sequence of permanganate, rinsing, one-step neutralization/cleaning/conditioning/micro-etching, followed by rinsing. The shortening of the process cycle in this way offers economic advantages in terms of shortened processing time, fewer processing tanks, less water and the like. In addition, the shortened process time and the reduced number of steps generally results in fewer processing errors or irregularities, thereby leading to economies related to overall yield of properly processed printed circuits. Still further, and perhaps most importantly, the reduced rinsing requirements lead directly to economies related to the minimizing of processing requirements for waste water streams, thus greatly minimizing ecological hardship.

In a particular embodiment of the invention, i.e., process cycles for through-hole metallization in double-sided or multilayer circuits in which a strong oxidizing agent such as permanganate or chromic acid is used to desmear and/or etch-back and/or otherwise alter the through-hole surfaces to be metallized, it is required, as previously discussed, that any residual manganese or chrome species be neutralized before catalysis and metallization. To this end, it is generally necessary to post-treat the surfaces with a relatively strong reducing agent. Also part of the process cycle is the subsequent contact of the multilayer circuit with a micro-etchant composition, i.e., agents which will etch exposed copper surfaces to remove a small degree of copper therefrom and in so doing micro-roughen the surface to improve absorption thereon of catalyst and adherence thereto of later-deposited metal. Such micro-etchants require an oxidizing agent or agents to effect removal of copper metal (e.g., persulfates, peroxide/sulfuric acid), and an agent (e.g., acid) which forms soluble copper salts of the removed, oxidized copper. Provision of a single composition to accomplish these neutralizing and micro-etching functions is inherently problematic in the required co-presence of a reducing agent and an oxidizing agent.

3

According to the invention in this regard, it surprisingly has been found possible to prepare an adequately stable aqueous solution containing the requisite components for achieving both the neutralizing and micro-etching functions, as by combining in aqueous solution a reducing agent such as hydrazine or a hydroxyl amine, an oxidizing component such as a cupric salt for etching copper, and an acid for formation of soluble copper salts with the etched copper. Compositions of this type enable combining into one step the neutralizing and micro-etching processes, and eliminate an intervening rinse step.

This preferred composition can be further supplemented by inclusion therein of agents effective to clean copper surfaces and to condition through-hole surfaces to enhance absorptivity of catalyst before metallization, as by inclusion therein of surface active or other suitable agents for attaining these effects, again with the surprising result of being able to harmonize all these components in a single, adequately stable aqueous solution. With compositions of this type, then, it is possible to combine into one step, and with elimination of numerous intervening rinses, the steps of neutralizing, cleaning, conditioning and micro-etching, with attendant savings associated with shorter process time, higher yields and reduced waste water processing requirements.

In describing the various and preferred embodiments of this invention, reference is made primarily to fabrication sequences for multilayer printed circuits, since such sequences are among the most complex in terms of the number of steps and the number of different processing compositions required, as well as in terms of the difficulties which must be addressed and the stringent specifications which must be met. It will be readily understood that much of the discussion herein has equal applicability to less complex printed circuits, such as double-sided printed circuits, including the circuitry innerlayers used in multilayer circuits.

So too, the description of the various and preferred embodiments of the invention generally focuses upon the particular steps in the overall fabrication sequence which lead up to metallization of the through-holes, starting generally with the treatment of the through-holes to prepare them for metallization.

In multilayer printed circuits, layers of copper-clad insulating substrate material are imaged and etched to form innerlayer circuitry layers. These innerlayers are alternatingly sandwiched between partially-cured insulating substrate layers ("pre-preg" sheets), typically employing an adhesion promoter (see, e.g., U.S. Patent Nos. 4,409,037 and 4,844,981) to promote adhesion between the pre-preg sheets and the copper metal of the circuitry innerlayers. The resultant layered arrangement, with outer-facing planar surfaces comprised of copper foil cladding, is pressed and heated to cure the insulating material layers and form an integral composite laminate for further treatment.

Through-holes are drilled or punched through the multilayer composite; when metallized, these through-holes serve to conductively interconnect the various circuitry layers of the multilayer circuit.

For the embodiments here discussed, it is assumed that the sequence is one wherein the through-hole-containing multilayer composite is then contacted with a relatively strong oxidizing agent, such as an alkaline permanganate solution, chromic acid or the like, to effect desmearing and/or etchback and/or alteration of the hole surface topography, all as earlier discussed and described. This "step" in the process can itself consist of numerous sub-steps, including solvent pretreatment and the like, but the salient point is that at the end of such treatment there will undesirably exist on the hole and other surfaces residual oxidizing species which must be neutralized before proceeding with further steps. See generally, U.S. Patent Nos. 4,597,988; 4,756,930; 4,601,783; and published PCT Application WO 89/10431, for discussion of such through-hole preparation processes based on permanganate.

There follows, then, the necessary process cycle for neutralizing, cleaning, conditioning and micro-etching, all as earlier discussed and described, and which will be returned to for later discussion herein.

Following these treatments, the metallization process is carried out for purposes of metallizing the through-hole surfaces as well as the exposed planar copper surfaces of the multilayer composite. The typical process is one of electroless metal plating, in which the surfaces to be plated are first activated by absorption thereon of species (or precursors thereof) catalytic to metal deposition from the electroless plating bath. The most commonly-employed catalytic materials are tin-palladium catalysts, used in a one-step activation process involving true or colloidal solutions of tin and palladium chloride. See, e.g., U.S. Patent Nos. 3,011,920 and 3,532,518. This activation process is generally followed by an acceleration step (see, e.g., U.S. Patent No. 4,608,275), although one-step catalysts also are known which do not require acceleration (see, e.g., U.S. Patent No. 4,863,758). Following activation, an electroless metal (typically copper) depositing bath is brought into contact with the activated surfaces to deposit metal thereon. These solutions may be of the formaldehyde-reduced variety or may be based upon other types of reducing agents, such as hypophosphite. See, e.g., U.S. Patent No. 4,209,331 and 4,279,948.

There follows after this metallization process numerous additional steps, well known in the art, for provision of a multilayer printed circuit to which solder connections of electronic components can be made and which can be electrically interconnected as appropriate in the assembly of some final article.

Returning to the neutralizing, cleaning, conditioning and micro-etching steps preparatory to metallization, these steps -- or more precisely the intended effects of these steps -- are quite critical to the overall fabrication process in that they in large part determine whether the electrical and physical integrity of the metallized through-holes will meet the stringent specifications required.

In a preferred embodiment of the invention, and as earlier discussed, compositions are provided in the form of suitably stable aqueous solutions of reducing agents capable of neutralizing the residual oxidizing species used in the previous desmear or like process, and oxidizing agents for micro-etching of copper surfaces, along with acid required to form soluble metal salts of the etched (oxidized) copper.

The neutralizing/reducing agent will be chosen depending upon the type of oxidizing species to be neutralized (e.g., manganese, chromium), as well as its ability to form an adequately (i.e, practically) stable solution with the oxidizing agent for micro-etching copper and with the solubilizing acid also included in the composition, while still retaining its intended functionality. Generally speaking, the neutralizing/reducing agent will be an amine derivative, with hydrazine or the hydroxyl amines (or their salts) being preferred, particularly for neutralization of residual manganese species.

It should be understood that by "reducing agent" is meant an agent or agents capable of reducing (hence, neutralizing) the particular oxidizing species used in the previous desmear or like processes. Thus, when alkaline permanganate is the oxidizing agent used in the desmear, etc. step, the residual permanganate species can be neutralized by an agent such as hydrogen peroxide which, although an oxidizing agent per se, nevertheless reduces permanganate and thus is a suitable reducing agent as such terminology is used herein.

The copper oxidizing agent will similarly be chosen for its ability to micro-etch the involved copper surfaces when utilized as part of the one-step composition, keeping in mind that the micro-etching process must be a controlled one in order to avoid too substantial removal of copper (by way of example, a typical copper foil surface will be on the order of 0.0014 inches (approx. 36 microns) in thickness, while the desired degree of micro-etching need remove only, say, about 1 to 5 microns thickness of copper). So too, the copper oxidizing agent also will be chosen for its compatibility with the other components of the composition, and particularly its ability to form a suitably stable aqueous solution with the included reducing agent. While a number of such oxidizing agents are suitable, particularly preferred are cupric salts, such as cupric chloride and cupric sulfate, either employed alone or with other suitable oxidizing agents for copper (e.g., persulfates).

The solubilizing acid will be chosen for its ability to provide a suitable pH for the copper micro-etching process and for its ability to form soluble salts of the copper etched (oxidized) in the process, as well as for its compatibility with the other components of the composition and its ability to form a suitably stable composition with these components. Suitable solubilizing acids include inorganic and organic acids, with hydrochloric acid being preferred for use with cupric oxidizing agents.

The concentrations of these agents in the aqueous composition will be chosen so as to be effective to attain the effect desired from each, i.e., neutralizing of permanganate or like oxidizing species, microetching of copper surfaces and solubilization of etched copper, and accordingly will necessarily be dependent upon the particular type of agent selected for such purpose. The concentrations also will be chosen on the basis of compatibility with the overall intent of providing a single, suitably stable composition containing all these components. By way of example, suitable stable aqueous compositions for use in cycles where alkaline permanganate is used in the desmear, etchback, etc. step, can contain from about 10 to about 80 g/l cupric chloride dihydrate, from about 10 to about 50 g/l hydroxylamine sulfate, and from about 100 to about 200 ml/l of hydrochloric acid (37%).

Of interest in regard of these compositions and their formulation, is that the reducing agent therein, which neutralizes residual oxidizing species from a prior permanganate or chromic acid through-hole treatment, appears to show some evidence of actually enhancing the copper micro-etching function in terms of topography produced on the copper surface. Still further, there is some evidence that for permanganate through-hole treatment cycles, the manganese species which become included in the neutralizing/microetching composition as the composition is contacted with the involved surface areas, may also themselves enhance the copper micro-etching function in terms of the topography produced and the rate of etching. Accordingly, it is within the contemplation of the invention that the reducing agent/micro-etchant composition can further include reduced manganese species (i.e., formed during utilization of the composition in its intended manner) or even as part of its initial make-up.

In the most preferred embodiment of the invention, the foregoing neutralizing/micro-etching composition is yet further supplemented by inclusion therein of agents which function to clean copper surfaces (e.g., by removal of organics such as soils, oils and the like) and agents (which may be the same or different from the cleaning agents) which function as through-hole conditioners to improve and uniformize absorption of catalyst on the through-hole surfaces. In this manner, a single composition can be provided for use after a permanganate or chromic acid or like through-hole treatment (desmear, etchback, etc.), and which functions to neutralize residual oxidizing species, clean and uniformly micro-etch copper surfaces and condition through-hole surfaces, thereby greatly reducing the number of individual steps and eliminating numerous intervening rinsing steps. Here again, it has surprisingly been found that adequately stable aqueous compositions can be formulated containing these numerous and disparate agents.

Typically, the agents required for the cleaning and conditioning functions are in the category of surface active agents (surfactants). For conditioning, the agents are generally cationic film-forming surfactants, and function to provide a uniform base for absorption of catalyst on the through-hole surfaces (made up, as earlier noted, of insulating material and metal innerlayer edges, and often further exhibiting exposed glass fibers). Another category of through-hole conditioners which can be employed are the organosilanes (see published PCT Application WO 88/02412, and corresponding U.S. Patent No. _____ (allowed application Ser. No. 331,039), both incorporated herein by reference). In certain instances, the conditioning agent (particularly if it is of the surfactant type) may also serve the function of cleaning soils, oils, etc. from the exposed copper surfaces and contribute to uniformity of copper micro-etching, but more typically a separate surfactant agent or agents will be included for these functions, be it an anionic, cationic or nonionic surfactant.

These cleaning and through-hole conditioning agents are incorporated into the composition at relatively low levels, e.g., on the order of from about 0.01 g/l to about 10 g/l for conditioner and, if a separate agent is required as a cleaner, from about 0.1 g/l to about 20 g/l for such agent.

According to further embodiments of the invention, there exist fabrication sequences where it is not necessary to desmear or etch-back through-hole surfaces, or where it is not necessary to employ a strong oxidizing agent for this purpose In such circumstances, the sequence does not require neutralization of residual oxidizing species and, in the context of the invention, compositions can be formulated without need for reducing agent to effect this neutralization. As such, adequately stable compositions formulated to contain copper micro-etching agents, solubilizing agents for the etched copper, cleaners and through-hole conditioners are provided in the invention, with all the attendant advantages of reducing the number of process steps, process time, and intervening rinses as compared to conventional sequences.

The compositions of this invention, be they designed for neutralizing and copper micro-etching; or for neutralizing, copper micro-etching, cleaning and conditioning; or for copper micro-etching, cleaning and conditioning, can be operated over a range of temperatures and residence times. Typical operation will be carried out at room temperature, and residence times of from about 0.5 to about 10 minutes.

As noted, the compositions of the invention are formulated as aqueous compositions which are stable in the sense of not undergoing any severe loss of functionality over reasonable periods of time, after initial make-up. As is well known in the art, there may be a relatively significant period of time between the manufacturer's make-up of the solution and the ultimate delivery to and use by the customer (printed circuit fabricator). If this lag period is exceedingly lengthy, it may be desirable to package one or more components of the composition separately for delivery to the customer and for the customer to make-up on site, in order to insure that there is no significant loss of functionality up to the time of use. This would be particularly appropriate for neutralizing/micro-etching compositions of the invention including both a reducing agent and a copper oxidizing agent, where separation of these agents at the manufacturer level will provide greater assurance that these inherently incompatible agents not interact so substantially over time as to result in loss of overall effectiveness and functionality. In all cases, the compositions are formulated so that functional stability is realized at the very least from the point of customer make-up to and through use in the intended and applicable fabrication sequence.

The invention is further described with reference to the following illustrative examples.

EXAMPLE 1

An aqueous composition was prepared containing 40 g/l cupric chloride dihydrate, 40 g/l hydroxylamine sulfate, 140 ml/l concentrated hydrochloric acid (37%), 1 g/l Triton X-100 (a non-ionic surfactant, available from Rohm & Haas Co.) and 0.3 g/l Cyastat (a cationic surfactant, available from American Cyanamid).

The composition was employed in the room temperature micro-etching of copper foil-clad epoxy panels (with mild agitation of the panels) to determine its effectiveness to micro-etch the copper surface (and thus provide a suitable topography for subsequent catalysis and electroless copper metallizing) notwithstanding the presence therein of the hydroxylamine sulfate reducing agent. For panels immersed for one minute, the extent of micro-etching was 0.85 microns (thickness); for other residence times, the results were: 2 minutes, 1.0 microns; 3 minutes, 1.4 microns; 4 minutes, 1.8 microns; and 5 minutes, 2.3 microns.

These results demonstrate quite acceptable micro-etching ability of the composition as compared to a cupric chloride dihydrate/HCl composition, thus indicating no loss of effectiveness and functionality even in the seemingly incompatible presence of reducing agent.

EXAMPLE 2

The composition of Example 1 was modified by varying the concentration of the cupric chloride dihydrate. Micro-etching results, expressed in terms of microns thickness removed in three (3) minutes, were as follows, indicating quite acceptable functionality

| $CuCl_2 \cdot 2H_2O$ (g/l) | 20 | 40 | 60 | 80 |
|---|---|---|---|---|
| Micro-Etch Rate | 0.9 | 1.4 | 2.3 | 3.2 |

EXAMPLE 3

The composition of Example 1 was modified by varying the concentration therein of hydroxylamine sulfate, and determining the capacity of the composition (10 ml.) to reduce 0.1N potassium permanganate, with the following results:

| Hydroxylamine Sulfate (g/l) | 10 | 20 | 30 | 40 |
|---|---|---|---|---|
| Ml. of 0.1N $KMnO_4$ reduced | 16 | 30 | 42.6 | 53 |

These results indicate that the compositions possess more than sufficient reducing capacity to neutralize residual manganese species in a typical fabrication sequence for through-hole-containing multilayer printed circuits, notwithstanding the seemingly incompatible presence in the composition of an oxidizing system for the micro-etching of copper.

EXAMPLE 4

The composition of Example 1 was modified by varying the concentrations of the Triton X-100 (0.3 g/l, 0.5 g/l, 1.0 g/l) and the Cyastat (0.3 g/l, 0.5 g/l, 1.0 g/l). Copper-clad epoxy panels having through-holes were treated at room temperature with this composition for 3 minutes, rinsed, activated and electrolessly metallized with copper. The panels were inspected during the sequence to assess the evenness, uniformity and extent of micro-etching, the adhesion of the electroless copper to the micro-etched copper surface, and the coverage of the through-holes with electroless copper. In addition, the compositions were tested for their permanganate reduction ability. All compositions were effective in this latter respect, and all compositions were effective in providing the requisite micro-etching, cleaning and through-hole conditioning, with the composition containing 1.0 g/l Triton X-100 and 0.3 g/l Cyastat being preferred in the particular functional set-up employed herein.

EXAMPLE 5

A composition was formulated as in Example 1, with the exception that the concentration of cupric chloride dihydrate was increased to 60 g/l. Micro-etching of copper-clad epoxy panels with the composition produced a loss of copper thickness of 1.35 microns for a 3 minute residence time, and 2.2 microns for a 5 minute residence time. Use of this composition as in Example 4 produced comparable acceptable results in terms of permanganate reduction capacity, evenness, uniformity and extent of copper micro-etching, electroless copper coverage and adhesion.

EXAMPLE 6

A composition was formulated as in Example 1, with the exception that the HCl concentration was reduced 20 ml/l and concentrated nitric acid included at 20 ml/l. Micro-etching of copper-clad epoxy panels with the composition produced a loss of copper thickness of 1.8 microns for a 3 minute residence time, and 2.3 microns for a 5 minute residence time. Use of this composition as in Example 4 produced comparable acceptable results in terms of all the criteria there noted.

EXAMPLE 7

A composition according to Example 1 was modified by varying the concentration of HCl therein (140 ml/l; 87 ml/l; 35 ml/l). In micro-etching copper-clad epoxy panels with these compositions, the following results were obtained:

| HCl (ml/l) | Minutes | Loss Of Cu Thickness (microns) |
|---|---|---|
| 140 | 3 | 2.0 |
| | 5 | 3.0 |
| 87 | 3 | 0.85 |
| | 5 | 1.2 |
| 35 | 3 | 0.7 |
| | 5 | 1.0 |

As can be seen, the micro-etching was accelerated with increasing HCl concentration, providing a means for regulating micro-etching to any desired degree without change in other essential components of the composition. In utilizing the compositions as in Example 4, all compositions, i.e., irrespective of HCl concentration, provided comparable acceptable results in terms of all the criteria there noted. It should further be noted that compositions of reduced HCl concentration are desirable in that they also have correspondingly less emission of acid fumes.

EXAMPLE 8

An aqueous composition was prepared containing 40 g/l cupric chloride dihydrate, 140 ml/l hydrochloric acid (37%), 1 g/l Triton X-100, 0.3 g/l Cyastat and 10 g/l hydroxylamine sulfate.

For investigating the functional stability of this composition over time, samples (10 ml.) of the composition were tested for permanganate reduction capacity upon initial make-up (day zero), and after standing idle for 3, 4, 5 and 6 days, with the following results:

| Day | 0 | 3 | 4 | 5 | 6 |
|---|---|---|---|---|---|
| Ml. of $KMnO_4$ (0.1N) reduced | 16 | 14 | 13 | 12 | 11.5 |

After standing idle for six days, the composition was utilized as in Example 4, and provided comparable acceptable results in terms of all the criteria there noted, i.e., uniformity, evenness and extent of micro-etching of the copper foil cladding; copper to copper adhesion after metallization; and electroless metal coverage of, and adhesion to, through-hole surfaces.

These results reflect satisfactory functional stability of the composition, notwithstanding the co-presence therein of reducing and oxidizing agents.

EXAMPLE 9

An aqueous composition was formulated as in Example 1, with omission of the hydroxylamine sulfate, and employed as in Example 4, with comparable acceptable results in terms of all parameters there noted, and with findings of a somewhat greater rate of copper micro-etching than for compositions containing hydroxylamine sulfate.

Compositions of this type are quite stable over long periods of time in terms of their micro-etching, cleaning and conditioning functionality, and are useful in a number of fabrication sequences, such as where residual oxidizing species from desmearing or etch-back treatment of the through-hole are separately neutralized before use of the inventive composition, or where the desmearing/etch-back does not leave residual oxidizing species on the surfaces, or where no desmearing/etch-back is employed.

EXAMPLE 10

A composition was prepared containing 40 g/l copper sulfate pentahydrate, 3 g/l hydrochloric acid (37%) and 1.0 g/l Triton X-100. Copper-clad epoxy panels were immersed in the bath for periods of thirty seconds to two minutes. The copper surface displayed a uniform matte surface, indicating a topography conducive to good copper-copper bonding in subsequent electrolytic copper plating, such as used in the subsequent pattern plating of printed circuits already having electroless metallized through-holes and copper surfaces. The desired topography was obtained with only minimal loss of copper thickness per se, a desirable feature which thereby avoids any potential for concurrent voiding of electroless copper already present on the through-holes.

EXAMPLE 11

A composition was prepared containing 10 g/l of a commercially-available copper micro-etchant (60% by weight sodium bisulfate/40% by weight sodium persulfate), 50 g/l cupric chloride dihydrate, 30 g/l sodium chloride, 30 g/l hydrogen peroxide, 0.3 g/l Cyastat and 1.0 g/l Triton X-100. This composition -- which contains no added HCl and thus has minimized acid fumes, and which utilizes hydrogen peroxide to neutralize/reduce permanganate residues from a prior desmear, etc. step, and which further utilizes a combination of oxidizing agents for copper micro-etching -- neutralized 10 mls. of 0.1N $KMnO_4$ (10 ml. sample), and etched 0.7 microns of copper from copper foil-clad epoxy panels (room temperature) in 5 minutes.

EXAMPLE 12

A composition was prepared according to Example 11 but with omission of the hydrogen peroxide. This composition, which is useful in situations such as those described in Example 9, and which has the advantage of no added HCl, etched 0.3 microns of copper thickness from copper foil-clad epoxy panels (room temperature) in 3 minutes, and 0.5 microns in 5 minutes.

EXAMPLE 13

A composition was prepared containing 10 g/l of the commercial copper micro-etchant described in Example 11, 40 g/l cupric chloride dihydrate, 10 g/l hydroxylamine sulfate, 80 g/l hydrochloric acid (37%), 1.0 g/l Triton X-100 and 0.3 g/l Cyastat. The composition was effective in neutralizing permanganate, and etched 1.1 microns of copper thickness from copper foil-clad epoxy panels in 5 minutes at room temperature.

EXAMPLE 14

A composition was prepared containing 50 g/l cupric chloride dihydrate, 30 g/l hydrogen peroxide, 80 g/l hydrochloric acid, 30 g/l sodium chloride, 0.3 g/l Cyastat and 1.0 g/l Triton X-100. The composition (10 ml. sample) was capable of neutralizing 14 ml. of 0.1N $KMnO_4$, and etched 1.3 microns of copper thickness from copper foil-clad epoxy panels in 3 minutes at room temperature, and 1.9 microns in 5 minutes.

As is apparent from the foregoing, the invention provides compositions which combine two or more functions traditionally achieved using separate compositions and intervening rinses. Compositions can be formulated to combine (a) functions of neutralizing oxidizing species remaining on relevant surfaces from a prior treatment of those surfaces with strong oxidizing agent for some particular purpose (e.g., desmearing or etch-back of through-holes); (b) functions of micro-etching of a copper surface to enhance its receptivity to adherence of a subsequently-applied metal plating, such as the electroless copper plating over copper foil incident to a through-hole metallization process, or the electrolytic copper plating over a previous electroless copper plating as encountered in patterning circuitry on plated through-hole circuits (see Example 10); (c) functions of cleaning copper surfaces to remove soils, oils, etc. therefrom preparatory to electroless or electrolytic plating; and (d) functions of conditioning through-hole surfaces to promote and uniformize catalyst absorption to the many different materials exposed at the through-hole surface prior to electroless metallization; along with related functions of promoting uniformity and evenness in any one or more of these steps.

The compositions are such that the agents or materials necessary for providing any given function can operate in their intended and expected manner without adverse interference from the co-presence of other separately-functional agents in the composition, some of which are often of a type which is functionally at odds with the function of the agents or materials in question. Indeed, in certain cases, agents or materials in the composition for one function may actually enhance the functionality of other differently-functional components. In addition, the composition are such that substantial functional stability is attainable, even where components of diametrically opposed individual functionality are co-present in the composition.

**Claims**

1. A process for fabricating a printed circuit containing metallized through-holes, from a through-hole-containing printed circuit precursor material or composite, which process comprises separate intermediate fabrication steps which are performed prior to metallization of the said through-holes, of neutralizing on the printed circuit precursor oxidizing species remaining thereon as a result of a previous treatment of the through-holes with an oxidizing agent, and micro-etching of exposed copper surfaces of the printed circuit precursor to enhance adhesion thereto of subsequently-deposited metal plating, with water rinsing between the neutralizing step and the micro-etching step, characterised by combining in one step the said neutralizing and the said micro-etching fabrication steps thereby to eliminate the water rinsing between such steps.

2. A process according to claim 1, wherein the combining into one step comprises contacting the printed circuit precursor with an aqueous composition comprising a reducing agent for effecting the neutralizing, a copper oxidizing agent for effecting the micro-etching of the copper, and a solubilizing acid for forming composition-soluble salts of etched copper.

3. A process according to claim 2, wherein the reducing agent is selected from hydrazine, a hydroxylamine, salts of a hydroxylamine, and mixtures thereof.

4. A process according to claim 2 or 3, wherein the copper oxidizing agent comprises a cupric salt.

5. A process according to claim 2, 3 or 4, wherein the solubilizing acid comprises an inorganic acid.

6. A process according to any one of claims 2 to 5, wherein the aqueous composition further comprises a cleaning agent to remove from exposed copper surfaces organics which otherwise detract from adhesion to the copper surfaces of subsequently deposited metal.

7. A process according to any one of claims 2 to 5, wherein the aqueous composition further comprises a through-hole conditioner for promoting absorption on the through-hole surfaces of species catalytic to subsequent metal plating.

8. A process for fabricating a printed circuit having metallized through-holes, from a through-hole-containing printed circuit precursor material or composite, which process comprises separate intermediate fabrication steps which are performed prior to metallization of the said through-holes, of conditioning the through-hole surfaces to promote absorption thereat of species catalytic to subsequent metal plating, and micro-etching exposed copper surfaces of the printed circuit precursor to enhance adhesion thereto of subsequently-deposited metal plating, with water rinsing between the micro-etching step and the conditioning step, characterised by combining in one step the said micro-etching and the said conditioning fabrication steps, thereby to eliminate the water rinsing between such steps.

9. A process according to claim 8, wherein the combining in one step comprises contacting the printed circuit precursor with an aqueous composition comprising a copper oxidizing agent, a solubilizing acid for forming composition-soluble salts of etched copper, and a through-hole conditioner.

10. A process according to claim 8, wherein the composition further comprises a cleaning agent for removing from the copper sufaces organics which otherwise detract from adhesion to the copper surfaces of subsequently deposited metal.

11. A process for fabricating a printed circuit having metallized through-holes, from a through-hole-containing printed circuit precursor material or composite, which process comprises separate intermediate fabrication steps which are performed prior to metallization of the through-holes, of (a) neutralizing on the printed circuit precursor oxidizing species remaining thereon as a result of previous treatment of the through-holes with an oxidizing agent; (b) cleaning the exposed copper surfaces to remove therefrom organics which otherwise detract from adhesion to the copper surfaces of subsequently-deposited metal plating, and conditioning the through-hole surfaces to promote absorption thereat of species catalytic to subsequent metal plating; and (c) micro-etching exposed copper surfaces of the printed circuit precursor to enhance adhesion thereto of subsequently-deposited metal plating; with water rinsing between one or more of said steps, characterised by combining into one step the said neutralizing, micro-etching, cleaning and conditioning fabrication steps, thereby to eliminate the water rinsing between such steps.

12. A process according to claim 11, wherein the combining into one step comprises contacting the printed circuit precursor with an aqueous composition comprising a reducing agent for effecting the neutralizing, a copper oxidizing agent for effecting micro-etching of the copper, a solubilizing acid for forming composition-soluble salts of etched copper, a cleaning agent, and a through-hole conditioner.

13. A process according to claim 12, wherein the reducing agent is selected from hydrazine, a hydroxylamine, salts of a hydroxylamine, and mixtures thereof.

14. A process according to claim 12 or 13, wherein the copper oxidising agent comprises a cupric salt.

15. A process according to claim 12, 13 or 14, wherein the solubilizing acid is an inorganic acid.

16. A process according to claim 15, wherein the solubilizing acid comprises hydrochloric acid.

17. A process according to any one of claims 12 to 16, wherein the cleaning agent comprises a surfactant.

18. A process according to any one of claims 11 to 17, wherein the through-hole conditioner comprises a cationic film-forming surfactant.

19. An aqueous composition for use in treatment of a printed circuit precursor material or composite in the course of fabricating a printed circuit, the composition comprising a reducing agent effective to neutralize oxidising species remaining on surfaces of the printed circuit precursor as a result of a previous treatment thereof with an oxidizing agent; a copper oxidizing agent effective to micro-etch exposed copper surfaces of said printed circuit precursor to enhance adhesion thereto of a subsequently-deposited metal plating; and a solubilizing acid effective to form composition-soluble salts of etched copper.

20. A composition according to claim 19, wherein the reducing agent is selected from hydrazine, a hydroxylamine, salts of a hydroxylamine, and mixtures thereof.

21. A composition according to claim 19 or 20, wherein the copper oxidizing agent comprises a cupric salt.

22. A composition according to claim 19, 20 or 21, wherein the solubilizing acid comprises an inorganic acid.

23. A composition according to any one of claims 19 to 22, consisting essentially of a hydroxylamine salt, cupric chloride and hydrochloric acid.

24. A composition according to any one of claims 19 to 23, further comprising a cleaning agent for removing from the copper surfaces organics which otherwise detract from adhesion to the copper surfaces of subsequently deposited metal.

25. A composition according to any one of claims 19 to 24, further comprising a conditioner for promoting absorption, on through-hole surfaces formed in the printed circuit precursor, of species catalytic to subsequent metal plating.

26. An aqueous composition for use in treatment of a printed circuit precursor material or composite in the course of fabricating a printed circuit, the composition comprising a copper oxidizing agent effective to

11

micro-etch exposed copper surfaces of the printed circuit precursor to enhance adhesion thereto of a subsequently-deposited metal plating, and a through-hole conditioner for promoting absorption, on through-hole surfaces formed in the printed circuit precursor, of species catalytic to subsequent metal plating.

27. A composition according to claim 26, further comprising a cleaning agent for removing from the copper surface organics which otherwise detract from adhesion to the copper surfaces of subsequently deposited metal.